# FASCICULE DE BREVET EUROPEEN

(11) **EP 3 903 340 B1**
(45) Date de publication et mention de la délivrance du brevet: **25.03.2026**
(21) Numéro de dépôt: 19848982.5
(22) Date de dépôt: 23.12.2019
(51) Int. Cl.: H01L 21/762, H10D 30/67, H10D 86/00

(54) **STRUCTURE DE TYPE SEMI-CONDUCTEUR POUR APPLICATIONS DIGITALES ET RADIOFRÉQUENCES**
HALBLEITERSTRUKTUR FÜR DIGITALE UND HOCHFREQUENTE ANWENDUNGEN
SEMICONDUCTOR STRUCTURE FOR DIGITAL AND RADIOFREQUENCY APPLICATIONS

(30) Priorité: 24.12.2018 FR 1874137
(43) Date de publication de la demande: 03.11.2021
(73) Titulaire: SOITEC, 38190 Bernin (FR)
(72) Inventeur: MORANDINI, Yvan, 73110 La Trinité (FR); SCHWARZENBACH, Walter, 38330 Saint-Nazaire-les-Eymes (FR); ALLIBERT, Frédéric, 38100 Grenoble (FR); DESBONNETS, Eric, 38660 Lumbin (FR); NGUYEN, Bich-Yen, Austin, Texas 78733 (US)
(74) Mandataire: Regimbeau
(86) Numéro de dépôt international: PCT/FR2019/053280
(87) Numéro de publication internationale: WO 2020/136343

(56) Documents cités:
- US-A1- 2005 082 531
- US-A1- 2006 261 410
- US-A1- 2006 292 770
- US-A1- 2018 337 043
- US-B1- 10 062 712
- US-B1- 9 824 891

## Description

### DOMAINE TECHNIQUE DE L'INVENTION

La présente invention concerne une structure de type semi-conducteur sur isolant pour des applications digitales et radiofréquences. L'invention se rapporte également à un procédé de fabrication d'une telle structure par transfert d'une couche d'un premier substrat, dit « substrat donneur », sur un deuxième substrat, dit « substrat receveur ».

### ETAT DE LA TECHNIQUE

Les structures de type semi-conducteur sur isolant sont des structures multicouches comprenant un substrat qui est généralement en silicium, une couche électriquement isolante agencée sur le substrat, qui est généralement une couche d'oxyde telle qu'une couche d'oxyde de silicium, et une couche semi-conductrice agencée sur la couche isolante dans laquelle sont réalisés la source, le canal et le drain des transistors, qui est généralement une couche de silicium.

De telles structures sont dites structure « Semiconductor on Insulator » (acronyme SeOI) en anglais, en particulier « Silicon on Insulator » (SOI) lorsque le matériau semi-conducteur est du silicium.

Parmi les structures SOI existantes, les structures dites « Fully-Depleted Silicon on Insulator » en anglais (acronyme FD-SOI) sont couramment utilisées pour des applications digitales. Les structures FD-SOI se caractérisent par la présence d'une couche mince d'oxyde, agencée sur un substrat en silicium, et d'une couche semi-conductrice très mince agencée sur la couche d'oxyde, dite couche SOI.

La couche d'oxyde se trouve entre le substrat et la couche SOI. La couche d'oxyde est alors dite « enterrée », et est appelée « BOX » pour Buried OXide en anglais.

La couche SOI permet d'implémenter le canal de conduction de la structure FD-SOI.

Du fait de la faible épaisseur et de l'uniformité de la couche de BOX et de la couche SOI, il n'est pas nécessaire de doper le canal de conduction, d'où le fait que la structure puisse fonctionner selon un mode totalement déplété.

Les structures FD-SOI présentent des caractéristiques électrostatiques améliorées par rapport aux structures sans couche de BOX. La couche de BOX diminue la capacité électrique parasite entre la source et le drain, et permet également de réduire considérablement les fuites d'électrons depuis le canal de conduction vers le substrat en confinant le flux d'électrons dans le canal de conduction, réduisant ainsi les pertes de courant électrique et améliorant les performances de la structure.

Les structures FD-SOI peuvent être compatibles avec des applications radiofréquences (RF), mais pâtissent cependant de l'apparition de pertes électriques dans ledit substrat.

Pour pallier ces pertes électriques et améliorer les performances RF, il est connu d'utiliser un substrat, notamment de type SOI, présentant une haute résistivité électrique, ce type de substrat étant communément appelé « substrat HR » pour substrat à haute résistivité. Ce dernier est avantageusement combiné avec une couche de piégeage de charges (« trap-rich layer » en anglais). Cependant, ce type de substrat n'est pas compatible avec une utilisation de transistors dont la tension de seuil peut être contrôlée par une grille en face arrière (« back bias voltage » en anglais »).

En effet, la présence de cette couche comportant des charges piégées gêne la polarisation en face arrière (application d'une différence de potentiel au niveau de la face arrière) et peut en outre conduire à une diffusion accélérée des dopants empêchant ainsi la réalisation de jonction PN de bonne qualité, à cause des problèmes de fuite de jonction.

Outre les structures FD-SOI comprenant une couche de BOX, des structures FD-SOI à deux couches de BOX, dites « double BOX » ont été réalisées.

La technologie à deux couches BOX est avantageuse dans le cas où la structure FD-SOI comprend des transistors à double grille dont les électrodes de grille sont formées à la fois au-dessus et en-dessous du canal de conduction. Ainsi, la couche SOI de la grille arrière, dite « back gate SOI layer », est séparée électriquement de la couche SOI de la grille avant, dite « front gate SOI layer », par une première couche de BOX, et est séparée électriquement également du substrat de base par une deuxième couche de BOX.

Chacun des documents US2006261410 et US 2010/0176482 décrit un exemple d'une telle structure FD-SOI à deux couches de BOX, pour une technologie CMOS.

Selon ce document, des structures CMOS avec un matériau de grille à haute constante diélectrique (« high-k material ») et avec une longueur de grille réduite jusqu'à 30 nm sont fabriquées selon un procédé optimisé permettant d'obtenir une bonne isolation entre les dispositifs et la grille arrière.

La technologie double BOX existante est utilisée pour des applications digitales, et non à la fois pour des applications radiofréquence et digitales.

### BREVE DESCRIPTION DE L'INVENTION

Un but de l'invention est de proposer une structure de type semi-conducteur sur isolant permettant de surmonter les inconvénients mentionnés précédemment. L'invention vise à proposer une telle structure permettant de combiner des applications digitales et des applications radiofréquence.

A cette fin, l'invention propose une structure de type semi-conducteur sur isolant comprenant :
- un empilement, dit empilement arrière, des couches suivantes depuis une face arrière vers une face avant de la structure :
   - un substrat support semi-conducteur dont la résistivité électrique est comprise entre 1 kΩ.cm et 30 kΩ.cm,
   - une première couche électriquement isolante,
   - une première couche semi-conductrice,
- au moins une tranchée d'isolation qui s'étend dans l'empilement arrière au moins jusque dans la première couche électriquement isolante, et qui isole électriquement deux régions adjacentes de la structure multicouche,
la structure multicouche étant principalement caractérisée en ce qu'elle comprend en outre:
- au moins une première région de type FD-SOI comprenant un empilement, dit empilement avant, agencé sur l'empilement arrière, ledit empilement avant comprenant :
   - une deuxième couche électriquement isolante agencée sur la première couche semi-conductrice,
   - une deuxième couche semi-conductrice dite couche active agencée sur la deuxième couche électriquement isolante,
   dans laquelle la première couche électriquement isolante présente une épaisseur supérieure à celle de la deuxième couche électriquement isolante, et la première couche semi-conductrice présente une épaisseur supérieure à celle de la couche active, ladite première portion FD-SOI comprenant en outre au moins un composant digital dans la couche active,
- au moins une deuxième région de type RF-SOI isolée électriquement de la région de type FD-SOI par une tranchée d'isolation, comprenant au moins un composant radiofréquence à l'aplomb de la première couche électriquement isolante..

Selon d'autres aspects, la structure proposée présente les différentes caractéristiques suivantes prises seules ou selon leurs combinaisons techniquement possibles :
- l'empilement arrière comprend en outre une couche de piégeage de charges agencée entre le substrat support et la première couche électriquement isolante ;
- la couche de piégeage de charges est en silicium polycristallin ou en silicium poreux ;
- le composant radiofréquence est agencé dans la première couche semi-conductrice ;
- la deuxième région de type RF-SOI comprend l'empilement avant agencé sur l'empilement arrière, et dans laquelle le composant radiofréquence est agencé dans la couche active ;
- la première couche semi-conductrice est en matériau cristallin ;
- la première couche semi-conductrice est en matériau amorphe ;
- la deuxième couche semi-conductrice est en matériau cristallin ;
- la première couche électriquement isolante est une couche d'oxyde de silicium ;
- la deuxième couche électriquement isolante est une couche d'oxyde de silicium ;
- la première couche électriquement isolante présente une épaisseur comprise entre 50 nm et 1500 nm ;
- la deuxième couche électriquement isolante présente une épaisseur comprise entre 10 nm et 100 nm ;
- la première couche semi-conductrice présente une épaisseur comprise entre 10 nm et 200 nm ;
la couche active présente une épaisseur comprise entre 3 nm et 30 nm.

L'invention se rapporte aussi à un procédé de fabrication d'une structure multicouche de type semi-conducteur sur isolant, comprenant les étapes suivantes :
- fourniture d'un premier substrat donneur,
- formation d'une zone de fragilisation dans ledit premier substrat donneur, de sorte à délimiter une première couche semi-conductrice,
- transfert de ladite première couche semi-conductrice sur un substrat support semi-conducteur, une première couche électriquement isolante étant à l'interface entre le substrat donneur et le substrat support de sorte à former un empilement arrière comprenant le substrat support, la première couche électriquement isolante, et la première couche semi-conductrice transférée,
- fourniture d'un second substrat donneur,
- formation d'une zone de fragilisation dans ledit second substrat donneur, de sorte à délimiter une deuxième couche semi-conductrice dite couche active,
- transfert de ladite couche semi-conductrice sur l'empilement arrière, une deuxième couche électriquement isolante étant à l'interface entre le second substrat donneur et l'empilement arrière, de sorte à former un empilement avant comprenant la deuxième couche électriquement isolante et la deuxième couche semi-conductrice transférée,
- formation d'au moins une tranchée d'isolation qui s'étend dans l'empilement avant et dans l'empilement arrière au moins jusque dans la première couche électriquement isolante, afin d'isoler électriquement deux régions adjacentes, dont au moins une région de type FD-SOI et au moins une région de type RF-SOI,
- réalisation :
   - d'au moins un composant digital dans la couche active, dans la région de type FD-SOI, et
   - d'au moins un composant radiofréquence à l'aplomb de la première couche électriquement isolante.

L'invention se rapporte également à un procédé de fabrication d'une structure multicouche de type semi-conducteur sur isolant, comprenant les étapes suivantes :
- formation d'un empilement arrière par dépôt d'une première couche semi-conductrice sur un substrat support recouvert d'une première couche électriquement isolante,
- fourniture d'un substrat donneur,
- formation d'une zone de fragilisation dans ledit substrat donneur, de sorte à délimiter une deuxième couche semi-conductrice,
- transfert de ladite deuxième couche semi-conductrice sur l'empilement arrière, une deuxième couche électriquement isolante étant à l'interface entre le second substrat donneur et l'empilement arrière, de manière à former un empilement avant sur l'empilement arrière,
- formation d'au moins une tranchée d'isolation qui s'étend dans l'empilement avant et dans l'empilement arrière au moins jusque dans la première couche électriquement isolante, afin d'isoler électriquement deux régions adjacentes, dont au moins une région de type FD-SOI et au moins une région de type RF-SOI,
- réalisation :
   - d'au moins un composant digital dans la couche active, dans la région de type FD-SOI, et
   - d'au moins un composant radiofréquence à l'aplomb de la première couche électriquement isolante.

Selon d'autres aspects, les procédés proposés présentent les différentes caractéristiques suivantes prises seules ou selon leurs combinaisons techniquement possibles :
- le procédé comprend, avant la réalisation du composant radiofréquence, une étape de retrait sélectif de la couche active et de la deuxième couche électriquement isolante de la région de type RF-SOI, et dans lequel le composant radiofréquence est ensuite formé dans la première couche semi-conductrice ;
- le procédé comprend en outre avant l'étape de transfert, la formation d'une couche de piégeage de charges sur le substrat receveur, ladite couche de piégeage de charges étant agencée entre le substrat support et la première couche électriquement isolante.

La structure multicouche de l'invention sert de support à la fabrication de transistors, en particulier des transistors à effet de champ de type MOSFET (« Metal Oxyde Semiconductor Field Effect Transistor » en anglais). Les transistors MOFSET sont des dispositifs semi-conducteurs à trois électrodes actives, dont une électrode d'entrée appelée grille, une électrode de sortie appelée drain, et une troisième électrode appelée source. Ces transistors permettent de contrôler une tension (ou un courant) de sortie sur le drain grâce à la grille.

Dans le présent texte, le terme « sur », qui se rapporte à la position d'une première couche par rapport à une deuxième couche, ou à la position un composant par rapport à une couche, n'implique pas nécessairement que la première couche soit directement au contact de la deuxième ou que le composant soit directement au contact de la couche. Sauf mention contraire, ce terme n'exclut pas qu'une ou plusieurs autres couches soient intercalées entre la première couche et la deuxième couche, ou entre le composant et la couche.

### DESCRIPTION DES FIGURES

D'autres avantages et caractéristiques de l'invention apparaîtront à la lecture de la description suivante donnée à titre d'exemple illustratif et non limitatif, en référence aux figures annexées suivantes :
La figure 1 est un schéma d'un premier mode de réalisation d'une structure multicouche selon l'invention, comprenant deux régions de type FD-SOI et une région de type RF-SOI, dans laquelle un composant digital est réalisé dans la couche active des régions de type FD-SOI et un composant radiofréquence est réalisé dans la couche active de la région de type RF-SOI ;
La figure 2 est un schéma d'un deuxième mode de réalisation d'une structure multicouche selon l'invention, comprenant deux régions de type FD-SOI et une région de type RF-SOI, dans laquelle un composant digital est réalisé dans la couche active des régions de type FD-SOI et un composant radiofréquence est réalisé dans la première couche semi-conductrice de la région de type RF-SOI ;
La figure 3A est un schéma illustrant la formation d'une zone de fragilisation dans un premier substrat donneur ;
La figure 3B est un schéma d'un empilement arrière obtenu après collage de la première couche semi-conductrice sur le substrat receveur ;
La figure 3C est un schéma illustrant la formation d'une zone de fragilisation dans un deuxième substrat donneur ;
La figure 3D est un schéma d'une structure obtenue après collage de la deuxième couche semi-conductrice sur l'empilement arrière ;
La figure 3E représente une structure multicouche obtenue par le procédé de fabrication selon un premier mode de réalisation ;
La figure 4A représente une structure multicouche dans laquelle a été réalisé un retrait local d'une portion de la couche active et de la deuxième couche électriquement isolante pour former une cavité ;
La figure 4B représente la structure de la figure 4A, obtenue par le procédé de fabrication selon un deuxième mode de réalisation ;
La figure 5A représente une structure munie de tranchées d'isolation ;
La figure 5B représente la structure de la figure 5A, dans laquelle a été réalisé un retrait local d'une portion latérale de la première couche semi-conductrice pour former une cavité, selon un troisième mode de réalisation du procédé de fabrication ;
La figure 5C représente la structure de la figure 5B, dans laquelle la cavité est comblée par une troisième couche électriquement isolante.

### DESCRIPTION DETAILLEE DE MODES DE REALISATION DE L'INVENTION

Un premier objet de l'invention concerne une structure multicouche de type semi-conducteur sur isolant, utilisable à la fois pour des applications digitales et pour des applications radiofréquences.

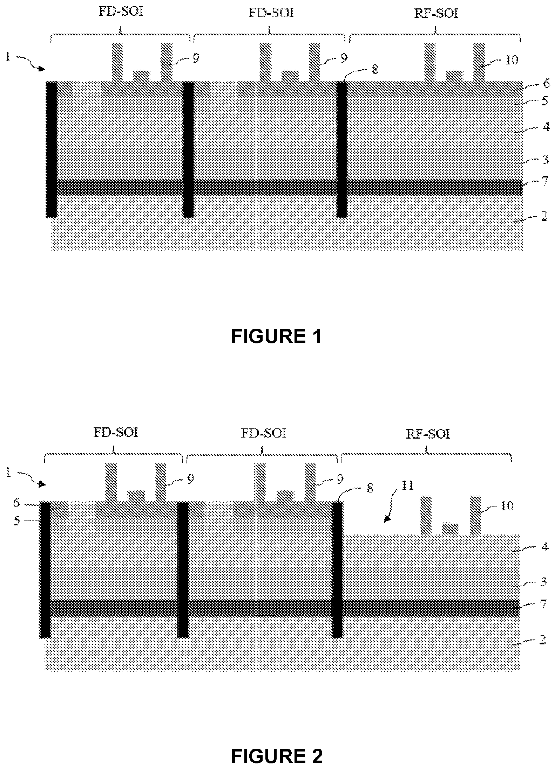

La figure 1 illustre un premier mode de réalisation d'une telle structure multicouche 1 selon l'invention.

En référence à la figure 1, la structure multicouche 1 comprend un empilement, dit empilement arrière, depuis une face arrière vers une face avant de la structure, d'un substrat support semi-conducteur 2, une première couche électriquement isolante 3, et une première couche semi-conductrice 4.

Le substrat support semi-conducteur 2 est un substrat hautement résistif, c'est-à-dire qu'il présente une résistivité électrique comprise entre 1 kΩ.cm et 10 kΩ.cm. Une résistivité élevée confère au substrat support la capacité de limiter les pertes électriques et d'améliorer les performances radiofréquences de la structure.

La première couche électriquement isolante 3 permet d'isoler le substrat support 2 de la première couche semi-conductrice 4 et des couches sus-jacentes à ladite première couche semi-conductrice.

La première couche électriquement isolante 3 est de préférence une couche d'oxyde. Cette couche étant enterrée dans la structure entre le substrat support 2 et la première couche semi-conductrice 4, elle peut également être appelée « premier BOX ». Il s'agit de préférence d'une couche d'oxyde de silicium.

L'épaisseur de la première couche électriquement isolante 3 est relativement élevée, et de préférence comprise entre 50 nm (nanomètres) et 1500 nm. Une épaisseur trop faible, en particulier inférieure à 50 nm, risque en effet d'aboutir à un claquage de la première couche électriquement isolante.

Optionnellement, la structure 1 comprend également une couche de piégeage de charges 7, préférentiellement en silicium polycristallin ou en silicium poreux agencée entre le substrat support 2 et la première couche électriquement isolante 3. Cette couche de piégeage de charges permet de piéger les charges électriques qui s'accumulent sous la première couche électriquement isolante 3.

La première couche semi-conductrice 4 est une couche intercalaire agencée entre la première couche électriquement isolante 3 et une deuxième couche électriquement isolante 5 décrite plus en détail dans la suite du présent texte. Elle présente de préférence une épaisseur comprise entre 10 nm et 200 nm.

La couche semi-conductrice 4 est avantageusement en matériau cristallin ou en matériau amorphe, éventuellement dopé dans les régions FD-SOI. Ce matériau est choisi pour que la couche semi-conductrice dans les régions FD-SOI puisse être polarisée pour contrôler la tension de seuil (« back bias voltage » en anglais ») du transistor.

De préférence, le matériau de la couche semi-conductrice 4 n'est pas dopé dans les régions RF-SOI afin d'optimiser la résistivité électrique de l'empilement arrière et de limiter ainsi les pertes électriques.

Le matériau de la couche semi-conductrice 4 est de préférence choisi parmi : le silicium monocristallin, le silicium polycristallin, le silicium-germanium.

La structure multicouche 1 comprend plusieurs régions destinées à des applications différentes, dont au moins une région de type FD-SOI pour des applications digitales et au moins une région de type RF-SOI pour des applications radiofréquences.

Afin de pouvoir combiner une région de type FD-SOI et une région de type RF-SOI dans une seule et même structure, la nature des couches constitutives de l'empilement situé sur la première couche semi-conductrice, dit empilement avant, est différente selon que ledit empilement fait partie d'une région de type FD-SOI ou d'une région une région de type RF-SOI.

Selon le premier mode de réalisation illustré sur la figure 1, les deux régions de type FD-SOI et la région de type RF-SOI comprennent un même empilement avant. Cet empilement avant comprend une deuxième couche électriquement isolante 5 agencée sur la première couche semi-conductrice 4, et une deuxième couche semi-conductrice 6 dite couche active agencée sur la deuxième couche électriquement isolante 5.

La structure 1 comprend en outre des tranchées d'isolation 8 qui s'étendent depuis la surface libre de la couche active 6, dans l'épaisseur de la structure. Les tranchées traversent la couche active 6 et la deuxième couche électriquement isolante 5 de l'empilement avant, et s'étendent dans l'empilement arrière au moins jusque dans la première couche électriquement isolante 3. Les tranchées peuvent s'étendre plus profondément dans l'empilement arrière, de manière à traverser la couche de piégeage de charges 7 lorsque celle-ci est présente, et le substrat support 2.

Chaque tranchée d'isolation isole électriquement deux régions adjacentes de la structure 1. Une tranchée sépare ainsi deux régions FD-SOI, ou deux régions RF-SOI, ou bien une région FD-SOI et une région RF-SOI.

Dans la structure de la figure 1, la deuxième couche électriquement isolante 5 s'étend sur la première couche semi-conductrice 4, à la fois dans les régions FD-SOI et dans la région RF-SOI.

La deuxième couche électriquement isolante 5 permet d'isoler la couche active 6 de la première couche semi-conductrice 4 et des couches sous-jacentes à la couche intercalaire.

La deuxième couche électriquement isolante 5 est de préférence une couche d'oxyde. Cette couche étant enterrée dans la structure entre la première couche semi-conductrice 4 et la couche active 6, elle peut également être appelée « deuxième BOX ». Il s'agit de préférence d'une couche d'oxyde de silicium.

La couche active 6 présente une épaisseur relativement faible, et inférieure à celle de la première couche électriquement isolante 3. Cette faible épaisseur permet de pouvoir assurer un contrôle de la tension de seuil du transistor par une polarisation adaptée de la première couche semi-conductrice sous-jacente. Une épaisseur de la deuxième couche électriquement isolante 5 de préférence comprise entre 10 nm et 100 nm est adaptée à cet effet.

La deuxième couche semi-conductrice 6 est appelée couche active car elle est destinée à la réalisation à la fois de composants digitaux 9 et de composants radiofréquences 10, ceux-ci étant fonction des applications digitales et radiofréquences souhaitées pour la structure.

La couche active 6 est de préférence en matériau cristallin, et de manière davantage préférée une couche de silicium monocristallin.

L'épaisseur de la couche active 6 est de préférence comprise entre 3 nm et 30 nm, et de manière davantage préférée entre 5 nm et 20 nm. On préfèrera que l'épaisseur de la couche active soit homogène sur l'ensemble du matériau, c'est-à-dire qu'elle présente une variation d'épaisseur inférieure ou égale à 1 nm, afin d'optimiser le fonctionnement des régions FD-SOI, selon un mode totalement déplété.

Selon le premier mode de réalisation représenté sur la figure 1, les composants radiofréquences sont réalisés sur l'empilement avant, dans la couche active 6.

La figure 2 illustre un deuxième mode de réalisation de la structure multicouche 1 selon l'invention.

Ce deuxième mode de réalisation diffère du premier en ce que l'empilement avant décrit précédemment est présent uniquement dans les régions FD-SOI, et les composants radiofréquences sont agencés directement dans la première couche semi-conductrice 4 de la région RF-SOI.

En référence à la figure 2, la région RF-SOI comprend ainsi la deuxième couche électriquement isolante 5 agencée sur la première couche semi-conductrice 4, et la couche active 6 agencée sur la deuxième couche électriquement isolante 5. En effet, la première couche électriquement isolante 3 permet déjà, sans la présence de la deuxième couche électriquement isolante 5, d'obtenir une structure suffisamment résistive pour limiter les pertes électriques.

Un procédé de fabrication d'une structure multicouche 1 telle que décrite précédemment va maintenant être décrit selon trois modes de réalisation.

**Selon un premier mode de réalisation,** on fournit initialement un premier substrat donneur 20.

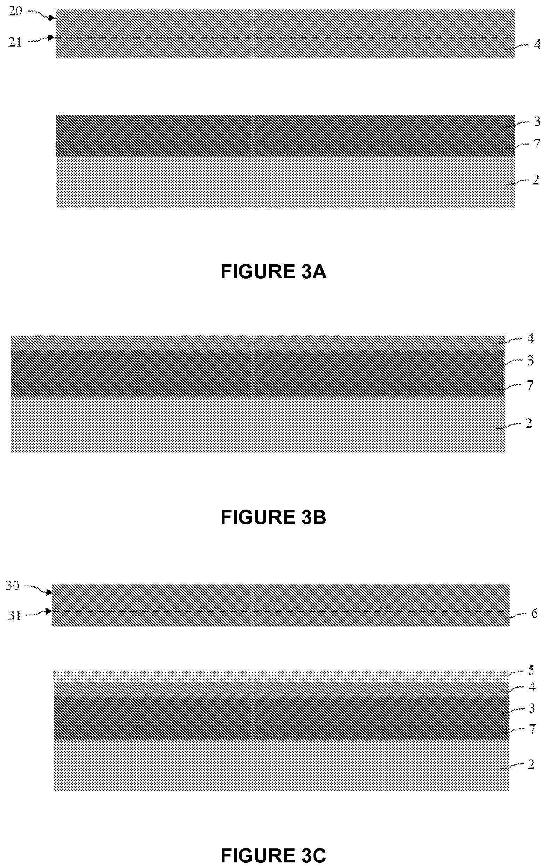

En référence à la figure 3A, on forme dans ce substrat une zone de fragilisation 21, de manière à délimiter une première couche semi-conductrice 4. La zone de fragilisation 21 est formée dans le substrat donneur à une profondeur prédéterminée qui correspond sensiblement à l'épaisseur de la couche semi-conductrice à transférer. De préférence, la zone de fragilisation 21 est créée par implantation d'atomes d'hydrogène et/ou d'hélium dans le substrat donneur 20.

On transfère ensuite la première couche semi-conductrice 4 sur un substrat support semi-conducteur 2, qui est un substrat receveur, en collant le substrat donneur 20 sur le substrat support par l'intermédiaire de la première couche électriquement isolante 3 puis en détachant le substrat donneur le long de la zone de fragilisation 21 (procédé Smart Cut^{™}). La première couche électriquement isolante peut être formée sur le substrat donneur ou sur le substrat support.

De manière alternative, le transfert peut être réalisé en amincissant le substrat donneur 21 par sa face opposée à la face collée sur le substrat support 2, jusqu'à l'obtention de l'épaisseur souhaitée pour la première couche semi-conductrice 4.

Optionnellement, avant l'étape de collage, on forme une couche de piégeage de charges 7 sur le substrat support, entre le substrat support 2 et la première couche électriquement isolante 3.

On obtient alors l'empilement arrière tel que décrit précédemment et représenté sur la figure 3B, comprenant le substrat support 2, la couche de piégeage de charges 7 lorsque présente, la première couche électriquement isolante 3, et la première couche semi-conductrice transférée 4.

Par ailleurs, on fournit un second substrat donneur 30.

En référence à la figure 3C, on forme dans ce substrat une zone de fragilisation 31, de manière à délimiter une deuxième couche semi-conductrice 6. La zone de fragilisation peut être formée de la même manière que pour délimiter la première couche semi-conductrice.

On transfère ensuite la deuxième couche semi-conductrice 6 sur l'empilement arrière qui forme un substrat receveur, en collant le second substrat donneur sur l'empilement arrière par l'intermédiaire de la deuxième couche électriquement isolante 5 puis en détachant le substrat donneur le long de la zone de fragilisation (procédé Smart Cut^{™}). La deuxième couche électriquement isolante 5 peut être formée sur le substrat donneur ou sur le substrat receveur.

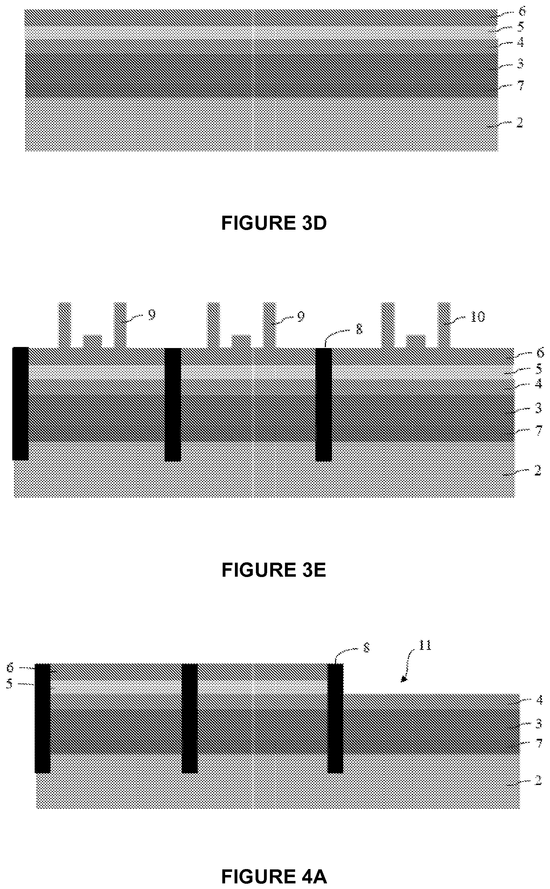

On obtient alors, en référence à la figure 3D, un empilement avant, comprenant la deuxième couche électriquement isolante 5 et la deuxième couche semi-conductrice 6, positionné sur l'empilement arrière.

De manière alternative, le transfert peut être réalisé en amincissant le second substrat donneur 30 par sa face opposée à la face collée sur l'empilement arrière, jusqu'à l'obtention de l'épaisseur souhaitée pour la deuxième couche semi-conductrice 6.

De manière optionnelle, avant l'étape de transfert, on peut procéder à un traitement de la surface libre de la première couche semi-conductrice afin d'en réduire la rugosité. Ce traitement de surface améliore le collage de la deuxième couche électriquement isolante sur la première couche semi-conductrice.

En référence à la figure 3E, on forme ensuite les tranchées d'isolation 8 qui s'étendent dans l'empilement avant et dans l'empilement arrière au moins jusque dans la première couche électriquement isolante 3, afin d'isoler électriquement deux régions adjacentes, notamment une région de type FD-SOI et une région de type RF-SOI.

Dans le cas où l'on souhaite obtenir la structure de la figure 2, on procède, avant la réalisation des composants radiofréquences 10 et de préférence avant la réalisation des composants digitaux 9, à un retrait sélectif d'une portion de la couche active 6 et de la deuxième couche électriquement isolante 5 des régions de type RF-SOI afin de former une cavité 11. Ceci est représenté sur la figure 4A.

Le retrait local peut avantageusement être réalisé par gravure. A cet effet, un masque de lithographie est déposé sur la couche active 6. Le masque est pourvu d'au moins une ouverture. La couche active 6 est ensuite gravée au travers de l'ouverture du masque afin de former la cavité 11. Toute technique de gravure connue convenant à cet effet est utilisable, comme par exemple une gravure sèche avec de l'acide chlorhydrique.

On réalise les composants digitaux 9 dans la deuxième couche semi-conductrice 6, qui est la couche active. Ceci permet d'obtenir une région de type FD-SOI.

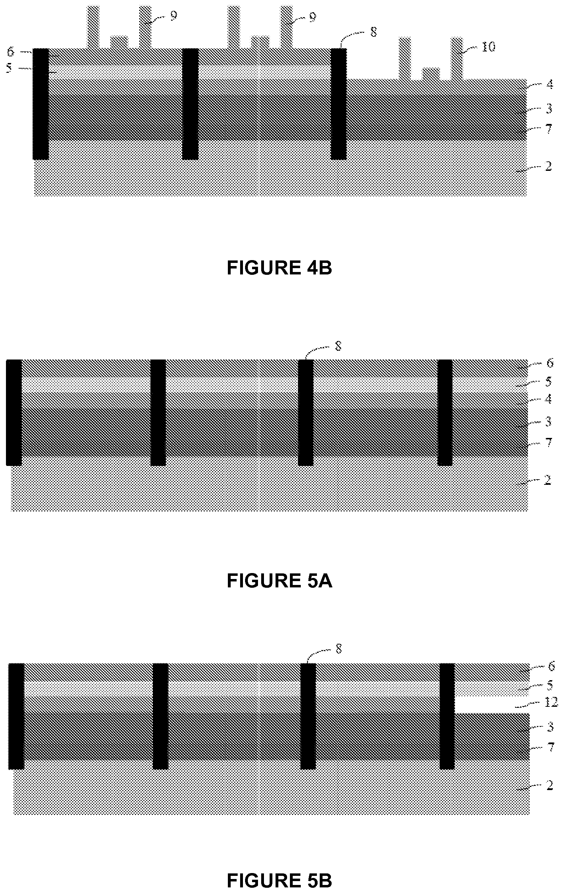

On réalise également les composants radiofréquences 10 sur la première couche semi-conductrice. Les composants radiofréquences peuvent être réalisés dans la couche active 6 (figure 1) ou dans la première couche semi-conductrice 4 (figure 2 et figure 4B). Ceci permet d'obtenir une région de type RF-SOI.

Le premier mode de réalisation qui vient d'être décrit comprend deux étapes de délimitation et de transfert d'une couche semi-conductrice. Ceci est tout particulièrement avantageux dans le cas où la première couche semi-conductrice est cristalline. Le transfert d'une telle couche depuis un substrat donneur permet de conserver sa qualité cristalline sur la structure finale.

Lorsqu'une optimisation de la qualité cristalline de la première couche semi-conductrice n'est pas requise, par exemple lorsque celle-ci est amorphe, il est possible de former la première couche semi-conductrice par dépôt sur la première couche électriquement isolante. Ce procédé ne met donc en jeu qu'une seule étape de transfert, c'est-à-dire celui de la couche active, et est donc plus économique.

Ce procédé correspond à un deuxième mode de réalisation qui va maintenant être décrit.

**Selon un deuxième mode de réalisation,** on forme un empilement arrière, en déposant une première couche semi-conductrice 4 sur un substrat support 2 recouvert préalablement d'une première couche électriquement isolante 3. Cet empilement arrière est illustré sur la figure 3B.

La première couche semi-conductrice 4 peut être formée par épitaxie sur le substrat support, ou alternativement déposée sur ledit substrat support notamment par dépôt chimique en phase vapeur, communément appelé selon la terminologie anglaise « Chemical Vapor Deposition » et désigné sous l'acronyme CVD.

Optionnellement, avant le dépôt de la première couche semi-conductrice, on forme une couche de piégeage de charges 7 sur le substrat support 2, entre le substrat support et la première couche électriquement isolante 3.

Par ailleurs, on fournit un substrat donneur 30.

En référence à la figure 3C, on forme dans ce substrat donneur une zone de fragilisation 31, de manière à délimiter une deuxième couche semi-conductrice 6. La zone de fragilisation peut être formée de la même manière que pour le premier mode de réalisation.

On transfère ensuite la deuxième couche semi-conductrice 6 sur l'empilement arrière, en collant le substrat donneur sur l'empilement arrière par l'intermédiaire de la deuxième couche électriquement isolante 5 puis en détachant le substrat donneur le long de la zone de fragilisation (procédé Smart Cut^{™}).

On obtient alors, en référence à la figure 3D, un empilement avant, comprenant la deuxième couche électriquement isolante 5 et la deuxième couche semi-conductrice 6, positionné sur l'empilement arrière.

De manière alternative, le transfert peut être réalisé en amincissant le substrat donneur 30 par sa face opposée à la face collée sur l'empilement arrière, jusqu'à l'obtention de l'épaisseur souhaitée pour la deuxième couche semi-conductrice 6.

De manière optionnelle, avant l'étape de transfert, on peut procéder à un traitement de la surface libre de la première couche semi-conductrice afin d'en réduire la rugosité. Ce traitement de surface améliore le collage de la deuxième couche électriquement isolante sur la première couche semi-conductrice, ce qui est particulièrement avantageux lorsque, comme dans le présent mode de réalisation, la première couche semi-conductrice est formée par dépôt et non par transfert Smart Cut^{™}.

En référence à la figure 3E, on forme ensuite les tranchées d'isolation 8 qui s'étendent dans l'empilement avant et dans l'empilement arrière au moins jusque dans la première couche électriquement isolante 3, afin d'isoler électriquement deux régions adjacentes, notamment une région de type FD-SOI et une région de type RF-SOI.

Dans le cas où l'on souhaite obtenir la structure de la figure 2, on procède, avant la réalisation des composants radiofréquences 10 et de préférence avant la réalisation des composants digitaux 9, à un retrait sélectif d'une portion de la couche active 6 et de la deuxième couche électriquement isolante 5 des régions de type RF-SOI afin de former une cavité 11. Ceci est représenté sur la figure 4A

Le retrait local peut avantageusement être réalisé par gravure, de manière similaire au premier mode de réalisation.

On réalise les composants digitaux 9 dans la deuxième couche semi-conductrice 6, qui est la couche active. Ceci permet d'obtenir une région de type FD-SOI.

On réalise également les composants radiofréquences 10 sur la première couche semi-conductrice. Les composants radiofréquences peuvent être réalisés dans la couche active 6 (figure 1) ou dans la première couche semi-conductrice 4 (figure 2 et figure 4B). Ceci permet d'obtenir une région de type RF-SOI.

**Selon un troisième mode de réalisation,** le procédé de fabrication comprend les mêmes étapes que celles du premier mode de réalisation ou celles du deuxième mode de réalisation, afin de former la structure de la figure 1 comprenant le substrat support semi-conducteur 2, la première couche électriquement isolante 3, la première couche semi-conductrice 4, la deuxième couche électriquement isolante 5, et la couche active 6. Cette structure est représentée sur la figure 5A.

Cependant, contrairement à ces deux modes de réalisation, on procède à un retrait local d'une portion de la première couche semi-conductrice 4. Ce retrait local peut être réalisé avant la réalisation des composants radiofréquences 10 et éventuellement des composants digitaux sur la couche active 6, ou bien après la réalisation des composants radiofréquences 10 et éventuellement des composants digitaux sur la couche active 6 c'est-à-dire pendant la fabrication du transistor. Il peut s'agir notamment d'un transistor de type MOS tel qu'un CMOS.

Selon ce troisième mode de réalisation, en référence à la figure 5A, on creuse une tranchée 8 à une distance déterminée du bord de la structure, de sorte que la tranchée s'étend depuis la surface libre de la couche active 6, à travers la deuxième couche électriquement isolante 5 et la première couche semi-conductrice 4, jusqu'à la première couche électriquement isolante 3. Ceci permet d'isoler physiquement la portion latérale délimitée par la tranchée 8 du reste de la structure.

En référence à la figure 5B, on procède ensuite à un retrait local de la première couche semi-conductrice 4 dans la portion latérale, afin de former une cavité 12.

La cavité 12 est une cavité latérale, située en bord de zone utile, et est ouverte sur l'extérieur de la structure. Elle est délimitée dans l'épaisseur de la structure par la première couche électriquement isolante 3 et la deuxième couche électriquement isolante 5, et latéralement par la tranchée 8.

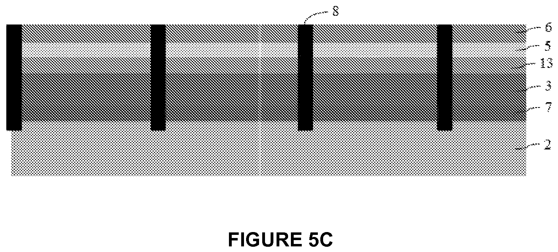

En référence à la figure 5C, on dépose ensuite une troisième couche électriquement isolante 13 dans la cavité 12, afin de remplir la cavité.

On peut ensuite réaliser un ou plusieurs composants radiofréquences 10 sur la couche active 6, à l'aplomb de la troisième couche électriquement isolante 7. On obtient alors une région de type RF-SOI en bord de structure. Les termes « à l'aplomb de » qui se rapportent à la position d'un composant par rapport à une couche au sein d'une structure, signifient que le composant et la couche se font face dans le sens de l'épaisseur de la structure. En d'autres termes, tout axe qui s'étend selon l'épaisseur de la structure et qui intercepte le composant, intercepte également la couche à l'aplomb de ce composant.

L'avantage de réaliser la troisième couche électriquement isolante durant le procédé de fabrication du transistor permet d'utiliser les masques de gravure de ce procédé, et donc de bénéficier d'un alignement optimal des différentes couches de la structure.

Selon un quatrième mode de réalisation (non représenté), on procède à un retrait local de la couche active 6, de la deuxième couche électriquement isolante 5 et de la première couche semi-conductrice 4, de manière à former une cavité.

On peut préalablement creuser une tranchée 8 dans la structure, de sorte que la tranchée s'étende depuis la surface libre de la couche active 6, à travers la deuxième couche électriquement isolante 5 et la première couche semi-conductrice 4, jusqu'à la première couche électriquement isolante 3. Ceci permet d'isoler physiquement la portion d'intérêt délimitée par la tranchée 8 du reste de la structure.

On remplit ensuite la cavité avec un oxyde, puis on réalise des composants radiofréquences passifs (inductances, capacités, lignes de conduction) sur la couche d'oxyde formée.

Les composants radiofréquences passifs ne nécessitent pas de matériau semi-conducteur tel que du silicium. Ils sont réalisés dans l'empilement arrière du circuit, avec les lignes de métal (dans une couche de diélectrique par exemple). Etant donné que ces composants RF passifs sont impactés négativement par les matériaux électriquement conducteurs, ils bénéficient fortement du substrat à haute résistivité et de la couche de piégeage de charges, ainsi que du retrait des couches semi-conductrices.

Selon un cinquième mode de réalisation (non représenté), on creuse une tranchée 8 dans la structure, de sorte que la tranchée s'étende depuis la surface libre de la couche active 6, à travers la deuxième couche électriquement isolante 5 et la première couche semi-conductrice 4, jusqu'à la première couche électriquement isolante 3. Ceci permet d'isoler physiquement la portion d'intérêt délimitée par la tranchée 8 du reste de la structure.

On procède à un retrait local de la couche active 6, de la deuxième couche électriquement isolante 5 et de la première couche semi-conductrice 4, de manière à former une cavité.

On réalise ensuite des composants radiofréquences passifs dans la tranchée. Pour cela, il est préférable que la couche active 6 et la deuxième couche électriquement isolante 5 ne soient pas trop épaisses. Une épaisseur comprise entre 3 nm et 30 nm pour la couche active 6 et une épaisseur comprise entre 10 nm et 100 nm pour la deuxième couche électriquement isolante 5 conviennent à cet effet.

Comme le troisième mode de réalisation, ces modes de réalisation présentent l'avantage d'utiliser les masques de gravure du procédé de fabrication du transistor, et donc de bénéficier d'un alignement optimal des différentes couches de la structure.

## Revendications

1. Structure multicouche (1) de type semi-conducteur sur isolant, comprenant :
- un empilement, dit empilement arrière, des couches suivantes depuis une face arrière vers une face avant de la structure :
un substrat support semi-conducteur (2) dont la résistivité électrique est comprise entre 1 kΩ.cm et 10 kΩ.cm,
une première couche électriquement isolante (3),
une première couche semi-conductrice (4),
- au moins une tranchée d'isolation (8) qui s'étend dans l'empilement arrière au moins jusque dans la première couche électriquement isolante (3), et qui isole électriquement deux régions adjacentes de la structure multicouche,
la structure multicouche (1) étant **caractérisée en ce qu'**elle comprend en outre :
- au moins une première région de type FD-SOI comprenant un empilement, dit empilement avant, agencé sur l'empilement arrière, ledit empilement avant comprenant :
une deuxième couche électriquement isolante (5) agencée sur la première couche semi-conductrice (4),
une deuxième couche semi-conductrice (6) dite couche active agencée sur la deuxième couche électriquement isolante (5),
dans laquelle la première couche électriquement isolante (3) présente une épaisseur supérieure à celle de la deuxième couche électriquement isolante (5), et la première couche semi-conductrice (4) présente une épaisseur supérieure à celle de la couche active (6), ladite première portion FD-SOI comprenant en outre au moins un composant digital (9) dans la couche active (6),
- au moins une deuxième région de type RF-SOI isolée électriquement de la région de type FD-SOI par une tranchée d'isolation (8), comprenant au moins un composant radiofréquence (10) à l'aplomb de la première couche électriquement isolante (3).

2. Structure (1) selon la revendication 1, dans laquelle l'empilement arrière comprend en outre une couche de piégeage de charges (7) agencée entre le substrat support (2) et la première couche électriquement isolante (3).

3. Structure (1) selon la revendication 2, dans laquelle la couche de piégeage de charges (7) est en silicium polycristallin ou en silicium poreux.

4. Structure (1) selon l'une des revendications 1 à 3, dans laquelle le composant radiofréquence (10) est agencé dans la première couche semi-conductrice (4).

5. Structure (1) selon l'une des revendications 1 à 3, dans laquelle la deuxième région de type RF-SOI comprend l'empilement avant agencé sur l'empilement arrière, et dans laquelle le composant radiofréquence (10) est agencé dans la couche active (6).

6. Structure (1) selon l'une des revendications précédentes, dans laquelle la première et/ou la deuxième couche semi-conductrice (4, 6) est en matériau cristallin.

7. Structure (1) selon l'une des revendications 1 à 5, dans laquelle la première couche semi-conductrice (4) est en matériau amorphe.

8. Structure (1) selon l'une des revendications précédentes, dans laquelle la première et/ou la deuxième couche électriquement isolante (3, 5) est une couche d'oxyde de silicium.

9. Structure (1) selon l'une des revendications précédentes, dans laquelle la première couche électriquement isolante (3) présente une épaisseur comprise entre 50 nm et 1500 nm et la deuxième couche électriquement isolante (5) présente une épaisseur comprise entre 10 nm et 100 nm.

10. Structure (1) selon l'une des revendications précédentes, dans laquelle la première couche semi-conductrice (4) présente une épaisseur comprise entre 10 nm et 200 nm.

11. Structure (1) selon l'une des revendications précédentes, dans laquelle la couche active (6) présente une épaisseur comprise entre 3 nm et 30 nm.

12. Procédé de fabrication d'une structure multicouche (1) de type semi-conducteur sur isolant, comprenant les étapes suivantes :
- fourniture d'un premier substrat donneur,
- formation d'une zone de fragilisation dans ledit premier substrat donneur, de sorte à délimiter une première couche semi-conductrice (4),
- transfert de ladite première couche semi-conductrice (4) sur un substrat support semi-conducteur (2) présentant une résistivité électrique comprise entre 1 kΩ.cm et 10 kΩ.cm, une première couche électriquement isolante (3) étant à l'interface entre le substrat donneur et le substrat support de sorte à former un empilement arrière comprenant le substrat support (2), la première couche électriquement isolante (3), et la première couche semi-conductrice (4) transférée,
- fourniture d'un second substrat donneur,
- formation d'une zone de fragilisation dans ledit second substrat donneur, de sorte à délimiter une deuxième couche semi-conductrice (6) dite couche active,
- transfert de ladite couche semi-conductrice (6) sur l'empilement arrière, une deuxième couche électriquement isolante (5) étant à l'interface entre le second substrat donneur et l'empilement arrière, de sorte à former un empilement avant comprenant la deuxième couche électriquement isolante (5) et la deuxième couche semi-conductrice (6) transférée,
- formation d'au moins une tranchée d'isolation (8) qui s'étend dans l'empilement avant et dans l'empilement arrière au moins jusque dans la première couche électriquement isolante (3), afin d'isoler électriquement deux régions adjacentes, dont au moins une région de type FD-SOI et au moins une région de type RF-SOI,
- réalisation :
d'au moins un composant digital (9) dans la couche active (6), dans la région de type FD-SOI, et
d'au moins un composant radiofréquence (10) à l'aplomb de la première couche électriquement isolante (3).).

13. Procédé de fabrication d'une structure multicouche (1) de type semi-conducteur sur isolant, comprenant les étapes suivantes :
- formation d'un empilement arrière par dépôt d'une première couche semi-conductrice (4) sur un substrat support (2) présentant une résistivité électrique comprise entre 1 kΩ.cm et 10 kΩ.cm et recouvert d'une première couche électriquement isolante (3),
- fourniture d'un substrat donneur,
- formation d'une zone de fragilisation dans ledit substrat donneur, de sorte à délimiter une deuxième couche semi-conductrice (6),
- transfert de ladite deuxième couche semi-conductrice (6) sur l'empilement arrière, une deuxième couche électriquement isolante (5) étant à l'interface entre le second substrat donneur et l'empilement arrière, de manière à former un empilement avant sur l'empilement arrière,
- formation d'au moins une tranchée d'isolation (8) qui s'étend dans l'empilement avant et dans l'empilement arrière au moins jusque dans la première couche électriquement isolante (3), afin d'isoler électriquement deux régions adjacentes, dont au moins une région de type FD-SOI et au moins une région de type RF-SOI,
- réalisation :
d'au moins un composant digital (9) dans la couche active (6), dans la région de type FD-SOI, et
d'au moins un composant radiofréquence (10) sur la première couche semi-conductrice (4).

14. Procédé selon la revendication 12 ou la revendication 13, comprenant avant la réalisation du composant radiofréquence (10), une étape de retrait sélectif de la couche active (6) et de la deuxième couche électriquement isolante (5) de la région de type RF-SOI, et dans lequel le composant radiofréquence (10) est ensuite formé dans la première couche semi-conductrice (4).

15. Procédé selon l'une des revendications 12 à 14, comprenant en outre avant l'étape de transfert, la formation d'une couche de piégeage de charges (7) sur le substrat receveur, ladite couche de piégeage de charges (7) étant agencée entre le substrat support (2) et la première couche électriquement isolante (3).

## Patentansprüche

1. Mehrschichtstruktur (1) vom Typ Halbleiter-auf-Isolator, umfassend:
- einen Stapel, bezeichnet als hinterer Stapel, aus den folgenden Schichten von einer Rückseite zu einer Vorderseite der Struktur:
ein Halbleiter-Trägersubstrat (2), dessen elektrischer Widerstand zwischen 1 kΩ.cm und 10 kΩ.cm liegt,
eine erste elektrisch isolierende Schicht (3),
eine erste halbleitende Schicht (4),
- mindestens einen Isolationsgraben (8), der sich im hinteren Stapel mindestens bis in die erste elektrisch isolierende Schicht (3) erstreckt und der zwei benachbarte Bereiche der Mehrschichtstruktur elektrisch isoliert,
wobei die Mehrschichtstruktur (1) **dadurch gekennzeichnet ist, dass** sie ferner umfasst:
- mindestens einen ersten Bereich vom Typ FD-SOI, der einen Stapel, bezeichnet als vorderer Stapel, umfasst, der auf dem hinteren Stapel eingerichtet ist, wobei der vordere Stapel umfasst:
eine zweite elektrisch isolierende Schicht (5), die auf der ersten halbleitenden Schicht (4) eingerichtet ist,
eine zweite halbleitende Schicht (6), bezeichnet als aktive Schicht, die auf der zweiten elektrisch isolierenden Schicht (5) eingerichtet ist,
wobei die erste elektrisch isolierende Schicht (3) eine größere Dicke als die zweite elektrisch isolierende Schicht (5) aufweist und die erste halbleitende Schicht (4) eine größere Dicke als die aktive Schicht (6) aufweist, wobei der erste FD-SOI-Abschnitt ferner mindestens eine digitale Komponente (9) in der aktiven Schicht (6) umfasst,
- mindestens einen zweiten Bereich vom Typ RF-SOI, der durch einen Isolationsgraben (8) vom Bereich vom Typ FD-SOI elektrisch isoliert ist, umfassend mindestens eine Hochfrequenzkomponente (10) senkrecht zur ersten elektrisch isolierenden Schicht (3).

2. Struktur (1) nach Anspruch 1, wobei der hintere Stapel ferner eine Ladungstrappingschicht (7) umfasst, die zwischen dem Trägersubstrat (2) und der ersten elektrisch isolierenden Schicht (3) eingerichtet ist.

3. Struktur (1) nach Anspruch 2, wobei die Ladungstrappingschicht (7) aus polykristallinem Silizium oder aus porösem Silizium besteht.

4. Struktur (1) nach einem der Ansprüche 1 bis 3, wobei die Hochfrequenzkomponente (10) in der ersten halbleitenden Schicht (4) eingerichtet ist.

5. Struktur (1) nach einem der Ansprüche 1 bis 3, wobei der zweite Bereich vom Typ RF-SOI den auf dem hinteren Stapel eingerichteten vorderen Stapel umfasst und wobei die Hochfrequenzkomponente (10) in der aktiven Schicht (6) eingerichtet ist.

6. Struktur (1) nach einem der vorstehenden Ansprüche, wobei die erste und/oder zweite halbleitende Schicht (4, 6) aus kristallinem Material besteht.

7. Struktur (1) nach einem der Ansprüche 1 bis 5, wobei die erste halbleitende Schicht (4) aus amorphem Material besteht.

8. Struktur (1) nach einem der vorstehenden Ansprüche, wobei die erste und/oder zweite elektrisch isolierende Schicht (3, 5) eine Siliziumoxidschicht ist.

9. Struktur (1) nach einem der vorstehenden Ansprüche, wobei die erste elektrisch isolierende Schicht (3) eine Dicke zwischen 50 nm und 1500 nm aufweist und die zweite elektrisch isolierende Schicht (5) eine Dicke zwischen 10 nm und 100 nm aufweist.

10. Struktur (1) nach einem der vorstehenden Ansprüche, wobei die erste halbleitende Schicht (4) eine Dicke zwischen 10 nm und 200 nm aufweist.

11. Struktur (1) nach einem der vorstehenden Ansprüche, wobei die aktive Schicht (6) eine Dicke zwischen 3 nm und 30 nm aufweist.

12. Verfahren zur Herstellung einer Mehrschichtstruktur (1) vom Typ Halbleiter-auf-Isolator, das die folgenden Schritte umfasst:
- Bereitstellen eines ersten Donorsubstrats,
- Bilden einer Schwächungszone in dem ersten Donorsubstrat, so dass eine erste halbleitende Schicht (4) begrenzt wird,
- Übertragen der ersten halbleitenden Schicht (4) auf ein Halbleiter-Trägersubstrat (2) mit einem elektrischen Widerstand zwischen 1 kΩ.cm und 10 kΩ.cm, wobei sich eine erste elektrisch isolierende Schicht (3) an der Grenzfläche zwischen dem Donorsubstrat und dem Trägersubstrat befindet, so dass ein hinterer Stapel gebildet wird, der das Trägersubstrat (2), die erste elektrisch isolierende Schicht (3) und die übertragene erste halbleitende Schicht (4) umfasst,
- Bereitstellen eines zweiten Donorsubstrats,
- Bilden einer Schwächungszone in dem zweiten Donorsubstrat, so dass eine zweite halbleitende Schicht (6), bezeichnet als aktive Schicht, begrenzt wird,
- Übertragen der halbleitenden Schicht (6) auf den hinteren Stapel, wobei sich eine zweite elektrisch isolierende Schicht (5) an der Grenzfläche zwischen dem zweiten Donorsubstrat und dem hinteren Stapel befindet, so dass ein vorderer Stapel gebildet wird, der die zweite elektrisch isolierende Schicht (5) und die übertragene zweite halbleitende Schicht (6) umfasst,
- Bilden mindestens eines Isolationsgrabens (8), der sich im vorderen Stapel und im hinteren Stapel mindestens bis in die erste elektrisch isolierende Schicht (3) erstreckt, um zwei benachbarte Bereiche, darunter mindestens einen Bereich vom Typ FD-SOI und mindestens einen Bereich vom Typ RF-SOI, elektrisch zu isolieren,
- Herstellen:
mindestens einer digitalen Komponente (9) in der aktiven Schicht (6) im Bereich vom Typ FD-SOI, und
mindestens einer Hochfrequenzkomponente (10) senkrecht zur ersten elektrisch isolierenden Schicht (3).

13. Verfahren zur Herstellung einer Mehrschichtstruktur (1) vom Typ Halbleiter-auf-Isolator, das die folgenden Schritte umfasst:
- Bilden eines hinteren Stapels durch Aufbringen einer ersten halbleitenden Schicht (4) auf ein Trägersubstrat (2) mit einem elektrischen Widerstand zwischen 1 kΩ.cm und 10 kΩ.cm und bedeckt mit einer ersten elektrisch isolierenden Schicht (3),
- Bereitstellen eines Donorsubstrats,
- Bilden einer Schwächungszone in dem Donorsubstrat, so dass eine zweite halbleitende Schicht (6) begrenzt wird,
- Übertragen der zweiten Halbleitende Schicht (6) auf den hinteren Stapel, wobei sich eine zweite elektrisch isolierende Schicht (5) an der Grenzfläche zwischen dem zweiten Donorsubstrat und dem hinteren Stapel befindet, so dass ein vorderer Stapel auf dem hinteren Stapel gebildet wird,
- Bilden mindestens eines Isolationsgrabens (8), der sich im vorderen Stapel und im hinteren Stapel mindestens bis in die erste elektrisch isolierende Schicht (3) erstreckt, um zwei benachbarte Bereiche, darunter mindestens einen Bereich vom Typ FD-SOI und mindestens einen Bereich vom Typ RF-SOI, elektrisch zu isolieren,
- Herstellen:
mindestens einer digitalen Komponente (9) in der aktiven Schicht (6) im Bereich vom Typ FD-SOI, und
mindestens einer Hochfrequenzkomponente (10) auf der ersten halbleitenden Schicht (4).

14. Verfahren nach Anspruch 12 oder Anspruch 13, umfassend vor der Herstellung der Hochfrequenzkomponente (10) einen Schritt des selektiven Entfernens der aktiven Schicht (6) und der zweiten elektrisch isolierenden Schicht (5) aus dem Bereich vom Typ RF-SOI, und wobei anschließend die Hochfrequenzkomponente (10) in der ersten halbleitenden Schicht (4) gebildet wird.

15. Verfahren nach einem der Ansprüche 12 bis 14, das ferner vor dem Übertragungsschritt die Bildung einer Ladungstrappingschicht (7) auf dem Empfangssubstrat umfasst, wobei die Ladungstrappingschicht (7) zwischen dem Trägersubstrat (2) und der ersten elektrisch isolierenden Schicht (3) eingerichtet ist.

## Claims

1. A semiconductor-on-insulator multilayer structure (1) comprising:
- a stack, called rear stack, of the following layers from a rear face to a front face of the structure:
a semiconductor support substrate (2) with an electrical resistivity between 1 kΩ.cm and 10 kΩ.cm,
a first electrically insulating layer (3),
a first semiconductor layer (4),
- at least one isolation trench (8) extending in the rear stack at least as far as the first electrically insulating layer (3) and electrically insulating two adjacent regions of the multilayer structure,
the multilayer structure (1) being **characterized in that** it further comprises:
- at least one first FD-SOI region comprising a stack, called front stack, arranged on the rear stack, said front stack comprising:
a second electrically insulating layer (5) arranged on the first semiconductor layer (4),
a second semiconductor layer (6), known as the active layer, arranged on the second electrically insulating layer (5),
wherein the first electrically insulating layer (3) has a thickness greater than that of the second electrically insulating layer (5), and the first semiconductor layer (4) has a thickness greater than that of the active layer (6), said first FD-SOI portion further comprising at least one digital component (9) in the active layer (6),
- at least one second RF-SOI region electrically isolated from the FD-SOI region by an isolation trench (8), comprising at least one radio frequency component (10) directly above the first electrically insulating layer (3).

2. Structure (1) according to claim 1, wherein the rear stack further comprises a charge trap layer (7) arranged between the support substrate (2) and the first electrically insulating layer (3).

3. Structure (1) according to claim 2, wherein the charge trapping layer (7) is made of polycrystalline silicon or porous silicon.

4. Structure (1) according to one of claims 1 to 3, wherein the radio frequency component (10) is arranged in the first semiconductor layer (4).

5. Structure (1) according to one of claims 1 to 3, wherein the second RF-SOI region comprises the front stack arranged on the rear stack, and wherein the radio frequency component (10) is arranged in the active layer (6).

6. Structure (1) according to one of the preceding claims, wherein the first and/or second semiconductor layer (4, 6) is made of crystalline material.

7. Structure (1) according to one of claims 1 to 5, wherein the first semiconductor layer (4) is made of amorphous material.

8. Structure (1) according to one of the preceding claims, wherein the first and/or second electrically insulating layer (3, 5) is a silicon oxide layer.

9. Structure (1) according to one of the preceding claims, wherein the first electrically insulating layer (3) has a thickness between 50 nm and 1500 nm and the second electrically insulating layer (5) has a thickness between 10 nm and 100 nm.

10. Structure (1) according to one of the preceding claims, wherein the first semiconductor layer (4) has a thickness between 10 nm and 200 nm.

11. Structure (1) according to one of the preceding claims, wherein the active layer (6) has a thickness between 3 nm and 30 nm.

12. Method for manufacturing a multilayer structure (1) of the semiconductor-on-insulator type, comprising the following steps:
- providing a first donor substrate,
- forming a weakening zone in said first donor substrate so as to delimit a first semiconductor layer (4),
- transferring said first semiconductor layer (4) onto a semiconductor support substrate (2), having an electrical resistivity between 1 kΩ.cm and 10 kΩ.cm , a first electrically insulating layer (3) being at the interface between the donor substrate and the support substrate so as to form a rear stack comprising the support substrate (2), the first electrically insulating layer (3), and the transferred first semiconductor layer (4),
- providing a second donor substrate,
- forming a weakening zone in said second donor substrate, so as to delimit a second semiconductor layer (6) called active layer,
- transferring said semiconductor layer (6) onto the rear stack, with a second electrically insulating layer (5) at the interface between the second donor substrate and the rear stack, so as to form a front stack comprising the second electrically insulating layer (5) and the transferred second semiconductor layer (6),
- forming at least one isolation trench (8) extending into the front stack and into the rear stack at least as far as the first electrically insulating layer (3), in order to electrically isolate two adjacent regions, including at least one FD-SOI region and at least one RF-SOI region,
- forming:
at least one digital component (9) in the active layer (6), in the FD-SOI region, and
at least one radio frequency component (10) directly above the first electrically insulating layer (3).

13. Method for manufacturing a multilayer structure (1) of the semiconductor-on-insulator type, comprising the following steps:
- forming a rear stack by depositing a first semiconductor layer (4) on a support substrate (2) having an electrical resistivity between 1 kΩ.cm and 10 kΩ.cm and covered with a first electrically insulating layer (3),
- providing a donor substrate,
- forming a weakening zone in said donor substrate so as to delimit a second semiconductor layer (6),
- transferring said second semiconductor layer (6) onto the rear stack, with a second electrically insulating layer (5) at the interface between the second donor substrate and the rear stack, so as to form a front stack on the rear stack,
- forming at least one isolation trench (8) extending into the front stack and into the rear stack at least as far as the first electrically insulating layer (3) , in order to electrically isolate two adjacent regions, including at least one FD-SOI type region and at least one RF-SOI type region,
- forming:
at least one digital component (9) in the active layer (6), in the FD-SOI region, and
at least one radio frequency component (10) on the first semiconductor layer (4).

14. Method according to claim 12 or claim 13, comprising, prior to the formation of the radio frequency component (10), a step of selectively removing the active layer (6) and the second electrically insulating layer (5) from the RF-SOI region, and wherein the radio frequency component (10) is then formed in the first semiconductor layer (4).

15. Method according to one of claims 12 to 14, further comprising, prior to the transfer step, the formation of a charge trapping layer (7) on the receiving substrate, said charge trapping layer (7) being arranged between the support substrate (2) and the first electrically insulating layer (3).
